(19) Europäisches Patentamt

European Patent Office

Office européen des brevets

(11) **EP 1 483 593 B1**

(12) **EUROPÄISCHE PATENTSCHRIFT**

(45) Veröffentlichungstag und Bekanntmachung des Hinweises auf die Patenterteilung:
**21.06.2006 Patentblatt 2006/25**

(21) Anmeldenummer: **03704667.9**

(22) Anmeldetag: **20.02.2003**

(51) Int Cl.:
*G01R 27/28* (2006.01)   *G01R 35/00* (2006.01)

(86) Internationale Anmeldenummer:
**PCT/EP2003/001737**

(87) Internationale Veröffentlichungsnummer:
**WO 2003/076956 (18.09.2003 Gazette 2003/38)**

(54) **VERFAHREN ZUM MESSEN DER EFFEKTIVEN DIREKTIVITÄT UND/ODER EFFEKTIVEN QUELLTOR-ANPASSUNG EINES SYSTEMKALIBRIERTEN VEKTORIELLEN NETZWERKANALYSATORS**

METHOD FOR MEASURING THE RESIDUAL SYSTEM DIRECTIVITY AND/OR THE RESIDUAL SYSTEM PORT IMPEDANCE MATCH OF A SYSTEM-CALIBRATED VECTOR NETWORK ANALYSER

PROCEDE DE MESURE DE LA DIRECTIVITE EFFECTIVE ET/OU DE L'ADAPTATION D'IMPEDANCE EFFECTIVE AU PORT SOURCE D'UN ANALYSEUR DE RESEAU VECTORIEL A ETALONNAGE SYSTEMIQUE

(84) Benannte Vertragsstaaten:
**DE FR GB**

(30) Priorität: **14.03.2002 DE 10211334**

(43) Veröffentlichungstag der Anmeldung:
**08.12.2004 Patentblatt 2004/50**

(73) Patentinhaber: **Rohde & Schwarz GmbH & Co. KG**
**81671 München (DE)**

(72) Erfinder:
• **REICHEL, Thomas**
  **85598 Baldham (DE)**
• **JÄGER, Harald**
  **88410 Bad Wurzach (DE)**

(74) Vertreter: **Körfer, Thomas**
**Mitscherlich & Partner,**
**Patent- und Rechtsanwälte,**
**Sonnenstrasse 33**
**80331 München (DE)**

(56) Entgegenhaltungen:
DE-A- 3 912 795     US-A- 4 703 433
US-A- 4 845 423     US-B1- 6 175 592

• **DATABASE EPODOC [Online] EUROPEAN PATENT OFFICE, THE HAGUE, NL; "EA Guidelines on the evaluation of vector network analysers (VNA)" XP001162754 in der Anmeldung erwähnt**
• **FRANKE U: "SELECTIVE DECONVOLUTION: A NEW APPROACH TO EXTRAPOLATION AND SPECTRAL ANALYSIS OF DISCRETE SIGNALS" INTERNATIONAL CONFERENCE ON ACOUSTICS, SPEECH & SIGNAL PROCESSING. ICASSP. DALLAS, APRIL 6 - 9, 1987, NEW YORK, IEEE, US, Bd. 3 CONF. 12, 6. April 1987 (1987-04-06), Seiten 1300-1303, XP000199886**
• **WANG SI-XIONG ET AL: "NEW ALGORITHEMS OF EXTRAPOLATION AND SPECTRAL ESTIMATION FOR DISCRETE BAND-LIMITED SIGNALS BASED ON FOURIER TRANSFORM" PROCEEDINGS OF THE INTERNATIONAL SYMPOSIUM ON CIRCUITS AND SYSTEMS. NEW ORLEANS, MAY 1 - 3, 1990, NEW YORK, IEEE, US, Bd. 2 CONF. 23, 1. Mai 1990 (1990-05-01), Seiten 1545-1548, XP000167087**
• **FERRARI P. ET AL: 'A complete calibration procedure for time domain network analyzers' MICROWAVE SYMPOSIUM DIGEST 01 Juni 1992, NEW YORK, NY, USA, IEEE, US, Seiten 1451 - 1454, XP010063114**

EP 1 483 593 B1

**Beschreibung**

Die Erfindung betrifft ein Verfahren zum Messen der effektiven Direktivität (residual system directivity) und/ oder der effektiven Quelltor-Anpassung (residual system port impedance match) eines Meßtores eines systemkalibrierten vektoriellen Netzwerkanalysators laut Oberbegriff des Anspruchs 1.

Die hohe Genauigkeit von vektoriellen Netzwerkanalysatoren (VNA) beruht darauf, daß vor der eigentlichen Messung von Betrag und Phase des komplexen Reflexionskoeffizienten der Netzwerkanalysator durch Anschalten von Kalibrierstandards an seine Meßtore kalibriert wird. Zwischenzeitlich gibt es eine Vielzahl von unterschiedlichen Kalibriermethoden. Die Häufigsten benutzen zur Systemkalibrierung Leerlauf-, Kurzschluß- und Anpassungs-Kalibrierstandards. Durch Anschluß dieser Kalibrierstandards an die Meßtore des Netzwerkanalysators können die im Netzwerkanalysator entstehenden Fehler, die zu einer Abweichung der Meßwerte vom wahren Wert führen, ermittelt und bei der anschließenden Objektmessung zur rechnerischen Fehlerkorrektur benutzt werden. Dies ist beispielsweise aus der DE 39 12 795 A1 bekannt. Diese bisher üblichen Kalibrierverfahren sind jedoch immer noch nicht genau genug.

Um die noch verbleibende restliche Unsicherheit der Direktivität bzw. Meßtor-Anpassung zu bestimmen, wird in einer EA-Richtlinie vorgeschlagen, an dem zu vermessenden Meßtor des vorher systemkalibrierten Netzwerkanalysators eine am Ausgang definiert fehlabgeschlossene bzw. kurzgeschlossene Präzisions-Koaxial-Luftleitung anzuschließen und den Reflexionskoeffizienten am Eingang dieser Luftleitung an einer Folge von Meßpunkten innerhalb eines vorgegebenen Frequenzbereiches des Netzwerkanalysators zu messen (EA-10/12, EA Guidelines on the Evaluation of Vector Network Analyzers (VNA), European co-operation for Accreditation, May 2000). Nach dieser Richtlinie wird allerdings nur die sog. Ripple-Amplitude der den Betrag des Reflexionskoeffizienten überlagernden Oszillation ausgewertet, wobei vereinfachend angenommen wird, daß diese Ripple-Amplitude in etwa identisch ist mit der effektiven Quelltor-Anpassung, was jedoch nur zutrifft, wenn die effektive Direktivität vernachlässigt wird. Diese bekannte Verifikationsvorschrift unter Verwendung einer Präzisions-Luftleitung ist daher relativ ungenau und ermöglicht keine genaue Abschätzung der zu erwartenden Meßunsicherheit geschweige denn eine Nachkorrektur der Fehlerkorrekturterme für die Quelltoranpassung.

Es ist Aufgabe der Erfindung, ein Meßverfahren aufzuzeigen und einen Kalibrierstandard-Satz zu schaffen, mit dem die effektive Direktivität und/oder effektive Quelltor-Anpassung wesentlich genauer ermittelt werden kann und zwar so genau, daß damit dann sogar die bei der Systemkalibrierung ermittelten und im Netzwerkanalysator abgespeicherten Fehlerkorrekturwerte entsprechend nachkorrigiert werden können.

Diese Aufgabe wird gelöst durch die Verfahren gemäß Anspruch 1 oder Anspruch 2 und einen Kalibrierstandard-Satz nach Anspruch 10.

Bei Netzwerkanalysatoren ist es an sich bekannt, mittels Fourier-Transformation entweder im Frequenzbereich oder in Zeitbereich zu arbeiten (US-Patentschrift 4,703,433 bzw. Ferrarie et al: "a complete calibration oricedure for time domain network analyzers", 1992 IEEE, 1-5 June 1992, New York, USA, XP010063114). Dabei ist es auch schon bekannt, bestimmte Abschnitte des Zeitbereiches durch sogenannte "gates" auszufiltern. Auch eine Messung der komplexen Reflexionskoeffizienten einer am Ausgang kurzgeschlossenen Präzisions-Luftleitung mit einem solchen Netzwerkanalysator im Zeitbereich ist bekannt (US-Patentschrift 4,703,433).

Durch die Anwendung dieser ansich bekannten Verfahrensweise ergänzt durch die Verfahrensschritte laut Anspruch 1 bzw. 2 ist es möglich, aus den gemessenen komplexen Reflexionskoeffizienten die effektive Direktivität bzw. die effektive Quelltor-Anpassung wesentlich genauer zu bestimmen, als dies nach der bekannten EA-Richtlinie möglich ist. Die ermittelten Meßwerte stehen mit einem Genauigkeitsniveau zu Verfügung, das dem der verwendeten Präzisions-Luftleitung entspricht. Dabei ist es unerheblich, ob die Impedanz der verwendeten Präzisions-Luftleitung von der Bezugsimpedanz des Netzwerkanalysators abweicht, da gemäß der Erfindung auch solche Impedanzabweichungen berücksichtigt werden können, sofern sie bekannt sind. Damit ist diese Korrektur auch zu relativ niedrigen Frequenzen hin möglich, bei denen die Impedanz der Luftleitung durch den geringer werdenden Skin-Effekt zunehmend vom Nennwert abweicht. Da beim erfindungsgemäßen Verfahren eine Impedanzabweichung der Luftleitung zulässig ist, können auch preiswertere Luftleitungen für die Messung benutzt werden, solange eine ausreichende Längshomogenität der Querschnittsabmessungen gewährleistet ist. Außerdem ist prinzipiell nur die Messung mit einer kurzgeschlossenen Präzisions-Luftleitung notwendig, während beim bekannten Verfahren zusätzlich noch unbedingt eine Messung mit einem definierten Fehlabschluß nötig ist. Die gemäß der Erfindung vorgesehene zusätzliche Messung mit einem definierten Fehlabschluß einer Luftleitung kann zur Aufdeckung von Bedienfehlern benutzt werden. Dadurch wird eine routinemäßige Überprüfung und Bestimmung des Restfehlers bei Netzwerkanalysatoren stark vereinfacht.

Ein besonderer Vorteil des erfindungsgemäßen Verfahrens ist, daß mit der erzielbaren Genauigkeit bei der Messung der effektiven Quelltor-Anpassung bzw. der effektiven Direktivität die eigentlichen Fehlerkorrekturwerte korrigiert werden können, die durch die vorhergehende Kalibrierung des Netzwerkanalysators gewonnen wurden und im Netzwerkanalysator abgespeichert sind. Auf diese Weise wird die Meßgenauigkeit eines solchen vektoriellen Netzwerkanalysators wesentlich erhöht und eine Meßgenauigkeit erreicht, die der Qualität der Präzisions-Luftleitung entspricht. Das erfindungsgemäße Verfahren kann sowohl bei Netzwerkanalysatoren mit nur einem Meßtor (Reflektometer) oder auch bei solchen mit zwei oder mehr Meßtoren angewendet werden. Bei mehreren Meßtoren erfolgt die Messung der effektiven Direktivität und der effektiven Quelltor-Anpassung an jedem der Meßtore gemäß dem erfindungsgemäßen Verfahren getrennt.

Nachdem die gemäß dem erfindungsgemäßen Verfahren in Abhängigkeit von der Frequenz gemessenen Werte für effektive Direktivität und effektive Quelltor-Anpassung im wesentlichen den bei der Systemkalibrierung des Netzwerkanalysators verwendeten Kalibrierstandards zuzurechnen sind, bietet sich an, diese gemessenen Restfehlerwerte auf einem geeigneten Datenträger beispielsweise als Meßprotokolle oder Diagramme oder als Digitalwerte auf einer Diskette abzuspeichern und dem bei der Systemkalibrierung zu verwendenden Kalibrier-Kit beizugeben, so daß der Benutzer nach dem Kalibrieren seines Netzwerkanalysators mit den Kalibrierstandards unmittelbar die ermittelten Restfehlerwerte in den Netzwerkanalysator eingeben und damit die dort abgespeicherten Kalibrierdaten entsprechend korrigieren kann.

Die Erfindung wird im folgenden anhand schematischer Zeichnungen und Diagrammen an einem mathematischen Modell näher erläutert. In der Zeichnung zeigen:

Fig. 1        den Signalflußgraphen eines VNA zur Impedanzmessung;

Fig. 2        den Signalflußgraphen einer fehlabgeschlossenen Leitung;

Fig. 3        ein Ersatzschaltbild einer fehlabgeschlossenen Luftleitung;

Fig. 4        Meßwerte für den Betrag des Reflexionskoeffizienten am Eingang der kurzgeschlossenen Luftleitung;

Fig. 5        Meßwerte für den komplexen Reflexionskoeffizienten am Eingang der kurzgeschlossenen Luftleitung in parametrischer Darstellung;

Fig. 6        die diskrete Fourier-Transformierte (DFT) des Reflexionskoeffizienten am Eingang der kurzgeschlossenen Luftleitung;

Fig. 7        verlängerte und gespiegelte Punktfolge;

Fig. 8        Ausfilterung des heruntergemischten Trägers mit Tiefpaß-Übertragungsfunktion;

Fig. 9        die Beträge des Reflexionskoeffizienten und der Trägerkomponente A im Vergleich;

Fig. 10        den Betrag des Seitenbandsignals;

Fig. 11        das Spektrum des Seitenbandsignals mit Tiefpaß-Übertragungsfunktion;

Fig. 12        die Komponente $B_n$ in Polarkoordinaten-Darstellung (Parameter: Frequenz in GHz). Das Teilbild rechts erhält man bei stark reduzierter Bandbreite des Tiefpaßfilters (1/40);

Fig. 13.        das Spektrum des Terms $S_{ac}/A^2$ mit Tiefpaß-Übertragungsfunktion;

Fig. 14        die Komponente $C_n/A_n^2$ in Polarkoordinaten-Darstellung (Parameter: Frequenz in GHz). Das Teilbild rechts erhält man bei reduzierter Bandbreite des Tiefpaß-Filters (1/5);

Fig. 15        die vektorielle Differenz der Meßergebnisse nach Fig. 14;

Fig. 16        die Ripple-Amplitude des Meßergebnisses nach Fig. 4 im Vergleich mit den Beträgen der Meßergebnisse für "residual system directivity" und "residual system port impedance match" nach der erfindungsgemäßen Methode (f/GHz=n/10);

Fig. 17        einen Ausschnitt aus dem Spektrum des heruntergemischten Signals nach Fig. 8, dargestellt für unterschiedliche Grade der Extrapolation. I: o. Extrapolation, o. Spiegelung, 400 Punkte. II: 1600 Punkte entsprechend Fig. 7 (8). III: entsprechend Fig. 18;

Fig. 18        die stark verlängerte und bis zu lokalen Extrema geführte Punktfolge mit Meßpunkten aus Fig. 1 und

Fig. 19    den prinzipieller Aufbau eines Netzwerkanalysators

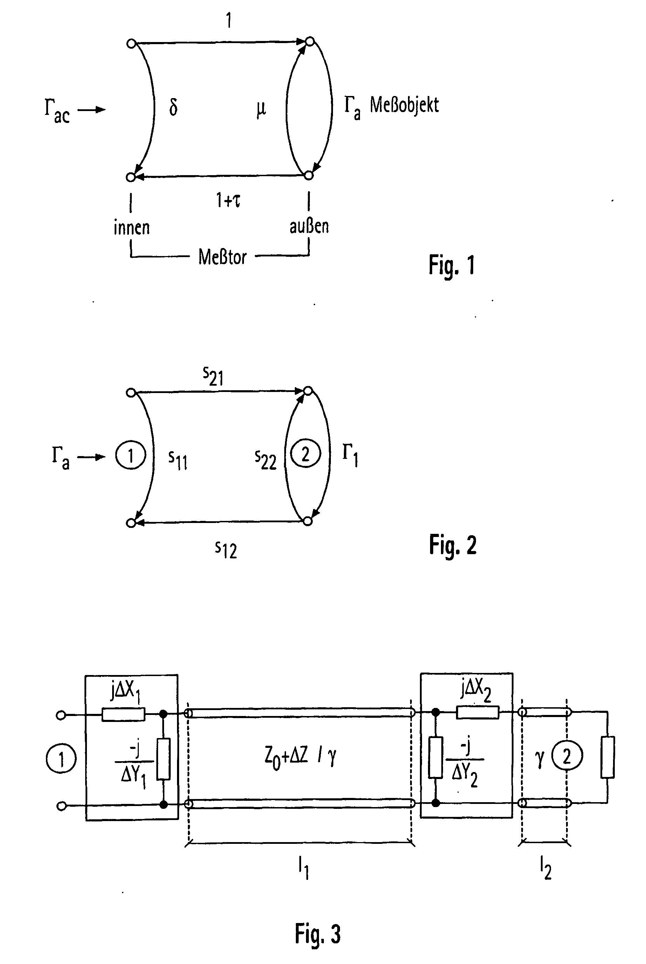

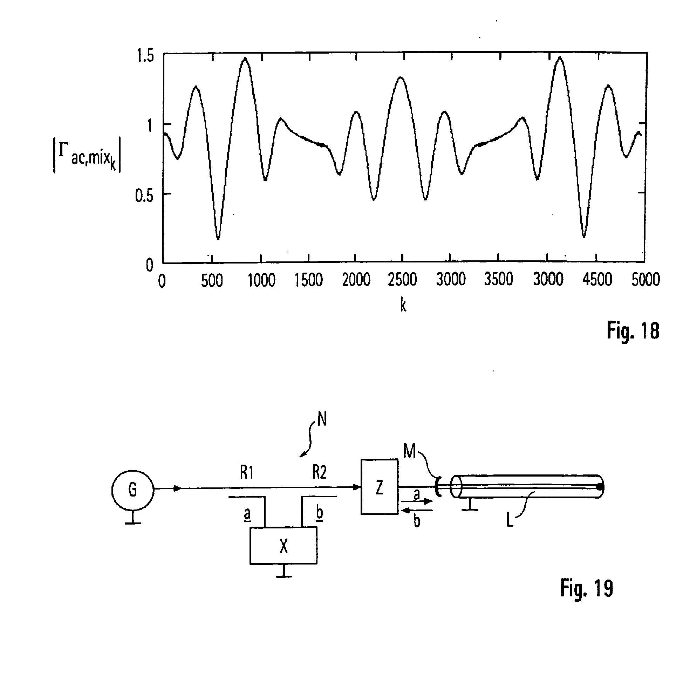

Fig. 19 zeigt den prinzipiellen Aufbau eines vektoriellen Netzwerkanalysators N und zwar der Einfachheit halber eines Netzwerkanalysators mit nur einem Meßtor M (Reflektometer). Ein eingebauter Generator G speist das Meßtor M (äußeres Meßtor bei Vergleich mit Fig. 1) mit einem Meßsignal veränderbarer Frequenz und zwar beispielsweise in äquidistanten Frequenzschritten zwischen 100 MHz bis 40 GHz. In die Verbindungsleitung zwischen Generator G und Meßtor M sind zwei Richtkoppler R1 und R2 eingefügt. Durch den einen R1 wird die Amplitude der hinlaufenden Welle a und durch den anderen R2 die Amplitude der rücklaufenden Welle b gemessen. Zum Kalibrieren eines derartigen Netzwerkanalysators werden am Meßtor M nacheinander verschiedene Kalibrierstandards wie Leerlauf, Kurzschluß und Anpassung angeschaltet und damit Kalibriermessungen durchgeführt. Die so ermittelten Fehlerwerte werden gedanklich in einem Fehlerzweitor Z zusammengefaßt und beispielsweise in einem Mikroprozessor X im Netzwerkanalysator als Fehlerkorrekturwerte abgespeichert.

Zur Abschätzung der Genauigkeit, mit der ein derartiger Netzwerkanalysator systemkalibriert ist, wird gemäß der Erfindung am Meßtor M eine koaxiale Präzisions-Luftleitung L einer vorgegebenen Mindestlänge angeschaltet, die an ihrem vom Meßtor M abgewandten Ausgang kurzgeschlossen ist. Mit dieser Luftleitung kann nun im Frequenzbereich des Generators G an einer Folge von äquidistanten Meßpunkten der komplexe Reflexionskoeffizient gemessen werden und daraus dann im Sinne des nachfolgenden mathematischen Modells die effektive Direktivität und/oder die effektive Quelltor-Anpassung bestimmt werden. Damit können dann die im Mikroprozessor X abgespeicherten Fehlerkorrekturwerte des Netzwerkanalysators ihrerseits korrigiert werden.

Beim nachfolgenden mathematischen Modell werden folgende Symbole verwendet:

$a_e$,    $b_e$ Prädiktionskoeffizienten

$A_{(n)}$    'Träger'-Signal innerhalb des aufgenommenen Satzes von Messwerten (n-ter Messpunkt)

$A'_{(n)}$    Heruntergemischtes 'Träger'-Signal (n-ter Messpunkt)

$\alpha$    Dämpfungskonstante der Referenz- Luftleitung

$B_{(n)}$    'Basisband'-Signal innerhalb des aufgenommenen Satzes von Messwerten (n-ter Messpunkt)

$\beta$    Phasenkonstante der Referenz-Luftleitung

cfft(x)    Diskrete (komplexe) Fourier-Transformierte

$C_{(n)}$    Signal bei der doppelten Trägerfrequenz innerhalb des aufgenommenen Satzes von Meßwerten (n-ter Meßpunkt)

$\delta$    Residual system directivity (effektive Direktivität)

$\Delta$    Error vector magnitude (Betrag des Fehlervektors)

$\Delta L_{1(2)}$    Ersatzinduktivität für den Einfluß des Steckers an Tor 1(2) der Referenz-Luftleitung

$\triangle C_{1(2)}$    Ersatzkapazität für den Einfluß des Steckers an Tor 1(2) der Referenz-Luftleitung

$\triangle X_{1(2)}$    Blindwiderstand (Reaktanz) in Serie zum Stecker 1(2) der Referenz-Luftleitung

$\triangle Y_{1(2)}$    Blindleitwert parallel zum Stecker 1(2) der Referenz-Luftleitung

e    Index

$E_a(e)$    Anzahl der durch lineare Prädiktion hinzugefügten Punkte am Anfang (a) bzw. Ende (e) der Folge von Meßpunkten

$F$    'Frequenz' des 'Träger'-Signals

$\gamma$    Ausbreitungskonstante der Referenz- Luftleitung

| $\Gamma_a$ | Reflexionskoeffizient eines Meßobjekts |
|---|---|
| $\Gamma_{ac}$ | Reflexionskoeffizient $\Gamma_a$ (nach Systemfehlerkorrektur) |
| $\Gamma_{ac_n}$ | n-ter Meßpunkt für $\Gamma_{ac}$ |
| $\Gamma_{ac,mixn}$ | Heruntergemischte Folge (n-ter Meßpunkt) |
| $\Gamma_l$ | Reflexionskoeffizient des Fehlabschlusses am Ausgang der Referenz-Luftleitung |
| $\kappa$ | Proportionalitätskonstante |
| $k$ | Index |
| $k_{max}$ | Maximalwert von $k$ |
| $l$ | Gesamtlänge der Leitung zwischen der Referenzebene des VNA und der Ebene des Fehlabschlusses |
| $l_1$ | Länge der Referenz-Luftleitung zwischen den Referenzebenen der beiden Stecker |
| $l_2$ | Länge des Leitungsabschnitts in der physikalischen Komponente 'Fehlabschluss' |
| $\mu$ | residual system port impedance match (effektive Quelltoranpassung) |
| $n, n_a, \quad n_e$ | Indizes |
| $N$ | Anzahl Meßpunkte |
| $v$ | Index |
| $p$ | Index |
| $P$ | Anzahl der Prädiktionskoeffizienten |
| $r_z$ | Normierte Impedanzabweichung der Referenz-Luftleitung (äqivalenter Reflexionsfaktor) |
| $s_{xy}$ | s-Parameter der Referenz-Luftleitung |
| $S_{ac_n}$ | Seitenbandsignal (n-ter Meßpunkt) |
| $t$ | Zeit |
| $t_1 (2)$ | Äquivalente Zeitkonstanten für den Steckereinfluß an Tor 1(2) der Referenz-Luftleitung |
| $T'$ | Schätzwert für den Reflexionsgleichlauf (tracking) |
| $\tau$ | residual system tracking |
| $\omega$ | Kreisfrequenz |
| $Z_0$ | Bezugsimpedanz des VNA |
| $\Delta Z$ | Impedanzabweichung der Referenz-Luftleitung |

Ausgehend von Fig. 1 gilt für den unter Berücksichtigung der Fehlerterme korrigierten Reflexionskoeffizienten eines Messobjekts:

$$\Gamma_{ac} \cong \delta + (1+\tau)\Gamma_a + \mu\Gamma_a^2 \qquad\qquad (1)$$

Für den eingangsseitigen Reflexionskoeffizienten einer mit $\Gamma_1$ fehlabgeschlossenen Luftleitung gilt nach Fig. 2:

$$\Gamma_a = s_{11} + \frac{s_{12}s_{21}}{1 - s_{22}\cdot\Gamma_l}\cdot\Gamma_l \qquad\qquad (2)$$

Unter Vernachlässigung von Produkten der Terme $\delta$, $\tau$, $\mu$, $s_{11}$ und $s_{22}$ miteinander erhält man:

$$\Gamma_{ac} \cong \delta + s_{11} + \left(1 + \tau + s_{22}\Gamma_l\right)s_{12}s_{21}\Gamma_l + \mu s_{12}^2 s_{21}^2 \Gamma_l^2 \qquad\qquad (3)$$

Zur Bestimmung der s-Parameter der Luftleitung wird das Ersatzschaltbild in Fig. 3 herangezogen. Der homogene Teil der Luftleitung zwischen den beiden Konnektoren habe dabei die Länge $l_1$ und werde durch die Ausbreitungskonstante $\gamma = \alpha + \beta$ sowie eine Impedanzabweichung $\triangle Z$ charakterisiert. Die kurze Leitung mit der Länge $l_2$ ist Teil des Fehlabschlusses mit dem Reflexionskoeffizienten $\Gamma_1$, und zwar der Abschnitt zwischen der Referenzebene und der Ebene des Fehlabschlusses. Die Impedanzabweichung dieses Abschnitts wird zu Null und die Ausbreitungskonstante so groß wie für den langen homogenen Leitungsabschnitt angenommen. Etwaige Impedanzabweichungen kann man in Form von Reaktanzen dem Halbglied zwischen den beiden Leitungsabschnitten zuschlagen. Die beiden Halbglieder repräsentieren die durch die HF-Konnektoren gebildeten Störstellen.

Mit

$$l = l_1 + l_2 \qquad\qquad (4)$$

gilt in einfacher Näherung

$$s_{12} = s_{21} \cong e^{-\gamma l} \qquad\qquad (5)$$

Für die Reflexionsparameter gilt:

$$
\begin{aligned}
s_{11} &= \frac{\Delta Z + \mathrm{j}\Delta X_1}{2Z_0} - \mathrm{j}\frac{\Delta Y_1 Z_0}{2} - \left[\frac{\Delta Z - \mathrm{j}\Delta X_2}{2Z_0} + \mathrm{j}\frac{\Delta Y_2 Z_0}{2}\right]e^{-2\gamma l_1} \\
&= \frac{\Delta Z + \mathrm{j}\Delta X_1}{2Z_0} - \mathrm{j}\frac{\Delta Y_1 Z_0}{2} - \left[\left[\frac{\Delta Z - \mathrm{j}\Delta X_2}{2Z_0} + \mathrm{j}\frac{\Delta Y_2 Z_0}{2}\right]e^{2\gamma l_2}\right]e^{-2\gamma l}
\end{aligned}
\qquad\qquad (6)
$$

$$
\begin{aligned}
s_{22} &= \left[\frac{\Delta Z + \mathrm{j}\Delta X_2}{2Z_0} - \mathrm{j}\frac{\Delta Y_2 Z_0}{2} - \left[\frac{\Delta Z - \mathrm{j}\Delta X_1}{2Z_0} + \mathrm{j}\frac{\Delta Y_1 Z_0}{2}\right]e^{-2\gamma l_1}\right]e^{-2\gamma l_2} \\
&= \left[\frac{\Delta Z + \mathrm{j}\Delta X_2}{2Z_0} - \mathrm{j}\frac{\Delta Y_2 Z_0}{2}\right]e^{-2\gamma l_2} - \left[\frac{\Delta Z - \mathrm{j}\Delta X_1}{2Z_0} + \mathrm{j}\frac{\Delta Y_1 Z_0}{2}\right]e^{-2\gamma l}
\end{aligned}
\qquad\qquad (7)
$$

1. Fall: $\Gamma_1 = -1$ (Verifikation mit ausgangsseitigem Kurzschluss)
Nach Einsetzen der Ausdrücke für $s_{11}$, $s_{22}$ und $s_{12}\,s_{21}$ in Gl. 3 erhält man:

$$\Gamma_{\mathrm{ac}} \cong \delta + \frac{\Delta Z + \mathrm{j}\left(\Delta X_1 - \Delta Y_1 Z_0^2\right)}{2Z_0} + \left[\mu - \frac{\Delta Z - \mathrm{j}\left(\Delta X_1 - \Delta Y_1 Z_0^2\right)}{2Z_0}\right] e^{-4\gamma l}$$
$$- \left[1 + \tau + \frac{\Delta Z}{Z_0}\sinh(2\gamma l_2) - \mathrm{j}\frac{\Delta X_2 - \Delta Y_2 Z_0^2}{Z_0}\cosh(2\gamma l_2)\right] e^{-2\gamma l} \qquad (8)$$

Mit Re $(2_\gamma l_2) \ll 1$ gilt die vereinfachte Beziehung

$$\Gamma_{\mathrm{ac}} \cong \delta + \frac{\Delta Z + \mathrm{j}\left(\Delta X_1 - \Delta Y_1 Z_0^2\right)}{2Z_0} + \left[\mu - \frac{\Delta Z - \mathrm{j}\left(\Delta X_1 - \Delta Y_1 Z_0^2\right)}{2Z_0}\right] e^{-4\gamma l}$$
$$- \left[1 + \tau + \mathrm{j}\frac{\Delta Z}{Z_0}\sin(2\beta l_2) - \mathrm{j}\frac{\Delta X_2 - \Delta Y_2 Z_0^2}{Z_0}\cos(2\beta l_2)\right] e^{-2\gamma l} \qquad (9)$$

Mit

$$\Delta X_1 = \omega \Delta L_1 \qquad (10)$$

$$\Delta X_2 = \omega \Delta L_2 \qquad (11)$$

$$\Delta Y_1 = \omega \Delta C_1 \qquad (12)$$

$$\Delta Y_2 = \omega \Delta C_2 \qquad (13)$$

gilt:

$$\Gamma_{\mathrm{ac}} \cong \delta + \frac{\Delta Z + \mathrm{j}\omega\left(\Delta L_1 - \Delta C_1 Z_0^2\right)}{2Z_0} + \left[\mu - \frac{\Delta Z - \mathrm{j}\omega\left(\Delta L_1 - \Delta C_1 Z_0^2\right)}{2Z_0}\right] e^{-4\gamma l}$$
$$- \left[1 + \tau + \mathrm{j}\left[\frac{\Delta Z}{Z_0}\sin(2\beta l_2) - \omega\frac{\Delta L_2 - \Delta C_2 Z_0^2}{Z_0}\cos(2\beta l_2)\right]\right] e^{-2\gamma l} \qquad (14)$$

Mit

$$r_z = \frac{\Delta Z}{2Z_0} \qquad (15)$$

$$t_1 = \frac{\Delta L_1 - \Delta C_1 Z_0^2}{2Z_0} \tag{16}$$

$$t_2 = \frac{\Delta L_2 - \Delta C_2 Z_0^2}{2Z_0} \tag{17}$$

erhält man schließlich:

$$\Gamma_{ac} \cong \delta + r_z + j\omega t_1 + \left[\mu - r_z + j\omega t_1\right]e^{-4\gamma l} - \left[1 + \tau + j\left[2r_z \sin(2\beta l_2) - 2\omega t_2 \cos(2\beta l_2)\right]\right]e^{-2\gamma l} \tag{18}$$

$\Gamma_{ac}$ ist eine Funktion der Frequenz, und im Falle eines linearen Sweeps,

$$\omega = \kappa t \tag{19}$$

auch eine Funktion der Zeit. Dann kann man sich $\Gamma_{ac}$ als Summe einer komplexen Schwingung mit dem Träger

$$A = -\left[1 + \tau + j\left[2r_z \sin(2\beta l_2) - 2\omega t_2 \cos(2\beta l_2)\right]\right]e^{-2\gamma l} \tag{20}$$

einem Basisband-Signal

$$B = \delta + r_z + j\omega t_1 \tag{21}$$

und einem Signal bei der doppelten Trägerfrequenz

$$C = \left[\mu - r_z + j\omega t_1\right]e^{-4\gamma l} \tag{22}$$

vorstellen, die zu dem charakteristischen Ripple von $|\Gamma_{ac}|$ über der Frequenz führen. Wie weiter unten gezeigt wird, lassen sich die genannten spektralen Anteile von $\Gamma_{ac}$ durch eine diskrete Fourier-Transformation (DFT) und anschließende Ausfilterung gewinnen, so daß die gesuchten Größen $\delta$ und $\mu$ wie folgt berechnet werden können:

$$\mu = C\frac{\left[1 + \tau + j\left[2r_z \sin(2\beta l_2) - 2\omega t_2 \cos(2\beta l_2)\right]\right]^2}{A^2} + r_z - j\omega t_1 \tag{23}$$

$$\delta = B - \left(r_z + j\omega t_1\right) \tag{24}$$

Gl. 23 kann weiter vereinfacht werden, ohne daß sich an der Genauigkeit, mit der $\mu$ bestimmt werden kann, viel ändert:

$$\mu \cong \frac{C}{A^2} + \left(r_z - j\omega t_1\right) \qquad\qquad (25)$$

Die Terme $r_z \pm j\omega t_1$ definieren einen Fehlervektor, der nur noch von der verwendeten Luftleitung herrührt und dessen Betrag der Impedanzabweichung (incl. Steckereinfluß) entspricht. Wenn dieser Vektor, oder zumindest die einfacher zu bestimmende Größe $r_z$, zur Verfügung steht, können auch Luftleitungen mit größerer Impedanztoleranz verwendet werden.

Die Korrektur der Fehlerterme 'system directivity' (Direktivität) D und 'system port impedance match' (Quelltoranpassung) M des VNA mit den gewonnenen Werten erfolgt mit folgenden Gleichungen:

$$D_{neu} = D_{alt} + \delta T' \qquad\qquad (26)$$

$$M_{neu} = M_{alt} + \mu \qquad\qquad (27)$$

2. Fall: $|\Gamma_1| < 0{,}1$ (Verifikation mit kleinem ausgangsseitigen Fehlabschluss)
Für diesen Fall kann zunächst Gl. 3 vereinfacht werden:

$$\Gamma_{ac} \cong \delta + s_{11} + \left(1 + \tau + s_{22}\Gamma_l\right)s_{12}s_{21}\Gamma_l \qquad\qquad (28)$$

Nach Einsetzen der s-Parameter der Luftleitung erhält man:

$$\Gamma_{ac} \cong \delta + \frac{\Delta Z + j\left(\Delta X_1 - \Delta Y_l Z_0^2\right)}{2Z_0} - \frac{\Delta Z - j\left(\Delta X_1 - \Delta Y_l Z_0^2\right)}{2Z_0}\Gamma_l^2 e^{-4\gamma l}$$
$$+ \left(\Gamma_l + \tau\Gamma_l + \left[\frac{\Delta Z + j\Delta X_2}{2Z_0} - j\frac{\Delta Y_2 Z_0}{2}\right]\Gamma_l^2\, e^{-2\gamma l_2} - \left[\frac{\Delta Z - j\Delta X_2}{2Z_0} + j\frac{\Delta Y_2 Z_0}{2}\right]e^{2\gamma l_2}\right)e^{-2\gamma l}$$

$$(29)$$

Das Signal enthält drei spektrale Komponenten - Basisband (unteres Seitenband), 'Träger' ($...\times e^{-2\gamma l}$) und oberes Seitenband ($...\times e^{-4\gamma l}$) - wobei das obere Seitenband auf Grund seiner Kleinheit nicht auswertbar sein dürfte. Der 'Träger' enthält keine interessanten Informationen, das Basisband ist identisch mit jenem, das bei kurzgeschlossener Luftleitung erhalten wird (Term *B* nach Gl. 21).

Im folgenden wird die Auswertung der Messergebnisse erläutert.

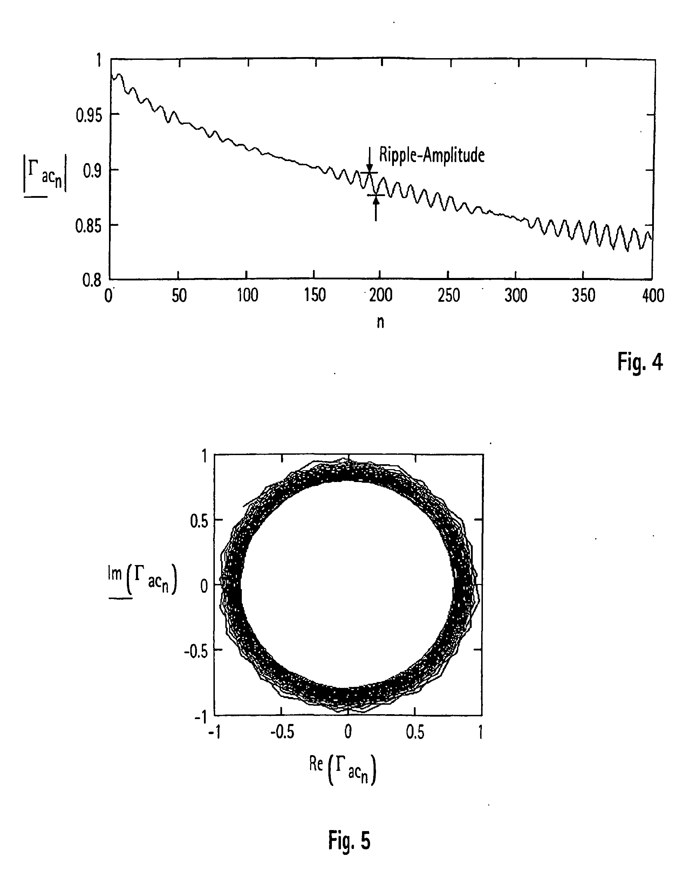

1. Fall: $\Gamma_1 = -1$ (Verifikation mit ausgangsseitigem Kurzschluss)
Nachfolgend wird die Bestimmung der Komponenten *B* und $C/A^2$ aus den Messergebnissen für $\Gamma_{ac}$ beschrieben. Dabei sei vorausgesetzt, dass N äquidistante Messpunkte $\Gamma_{ac_n}$ ($n=0...N$-1) vorliegen (Fig. 4 und 5):

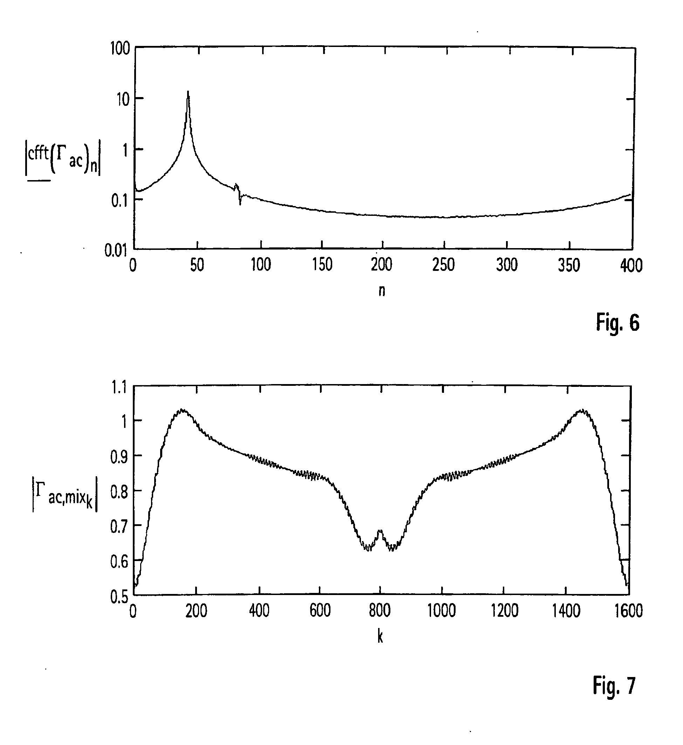

   1) Fouriertransformation mit Suche der dominierenden Komponente F (Fig. 6).
   2) Nullmischung des Trägers durch Multiplikation der $\Gamma_{ac_n}$ mit $e^{j2\pi F n}$ N:

$$\Gamma_{ac,mix_n} = \Gamma_{ac_n} \cdot e^{j2\pi F \frac{n}{N}} \tag{30}$$

3) Verlängerung der Punktefolge $\Gamma_{ac,mix_n}$ durch Hinzufügen von $E_e$ Punkten am Ende $(n_{e=}$ $N... N+E_e$ -1), die durch Extrapolation mit einem linearen Prädiktor über die letzten P Punkte (p = $N$-$P$-1... $N$-1) gewonnen werden.

4) Verlängerung der Punktefolge durch Hinzufügen von $E_a$ Punkten am Anfang $(n_a =$- $E_a$...-1), die dadurch gewonnen werden, dass die gespiegelte Folgeh $_{ac,mix_v}=\Gamma_{ac,mix_{N+Ea}-1v}$ ($v$ = 0... $N+E_e$ -1) auf die unter 3) beschriebene Weise extrapoliert wird.

5) Die extrapolierte gespiegelte Folge von 4) mit $N$ + $E_a$ + $E_e$ Punkten wird zurückgespiegelt und daran die Folge von 4) angehängt, so dass eine neue Folge $\Gamma_{ac,mix_k}$ mit $k$ = 2 ($N$ + $E_a$ + $E_e$) Punkten entsteht. Anfangs- und Endpunkt haben per Definition denselben Wert (Fig. 7).

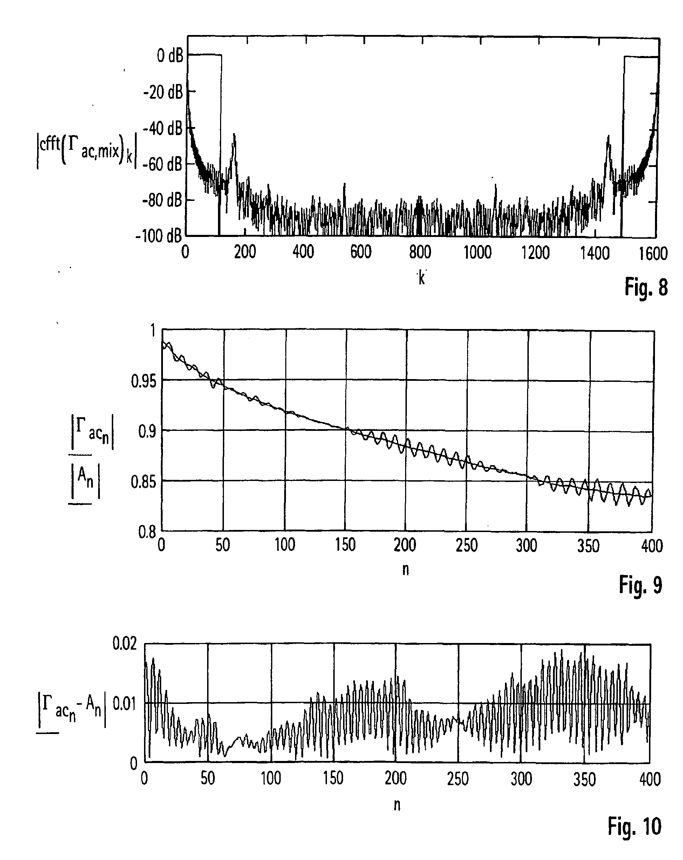

6) Diskrete Fourier-Transformation und. Gewinnung des heruntergemischten Trägers mit einem idealen Tiefpassfilter (rechteckförmige Übertragungsfunktion, keine Laufzeit, s. Fig. 8).

7) Inverse Fouriertransformation des Trägers und Ausschneiden des interessierenden Abschnitts der A'$_n$(n=0...$N$ - 1).

8) Gewinnung des Trägers in der Originallage durch Heraufmischen (Fig. 9):

$$A_n = A'_n \, e^{-j2\pi F \frac{n}{N}} \tag{31}$$

9) Subtraktion des Trägers von $\Gamma_{ac_n}$, so daß das Basisbandsignal und das Signal bei der doppelten Trägersequenz übrig bleiben (Fig. 10):

$$S_{ac_n} = \Gamma_{ac_n} - A_n \tag{32}$$

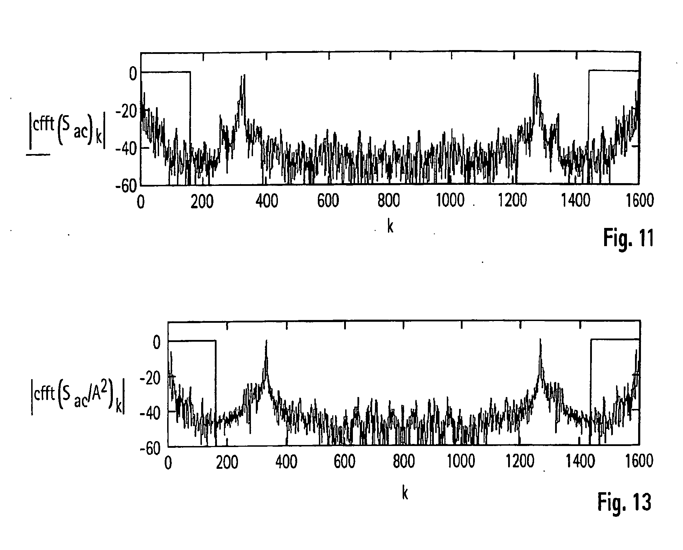

10) Gewinnung des Basisbandsignals ($B_n$) von $S_{ac}$ (Fig. 11,

12) analog zu 3) bis 7).

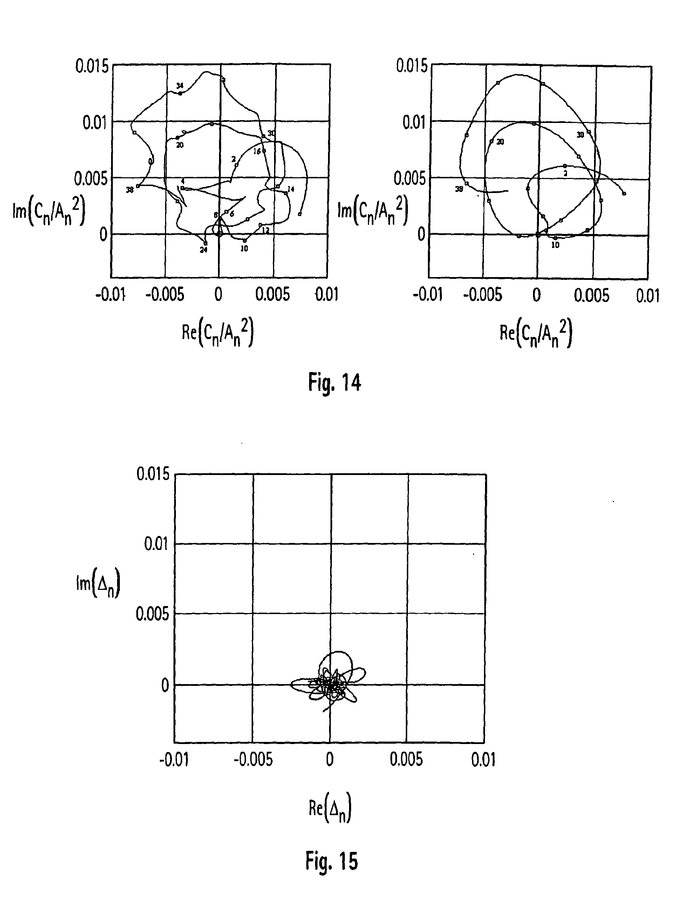

11) Gewinnung des Terms $C_n/A^2_n$ aus $S_{ac}/A^2$ (Fig. 13, 14, 15) analog zu 3) bis 7).

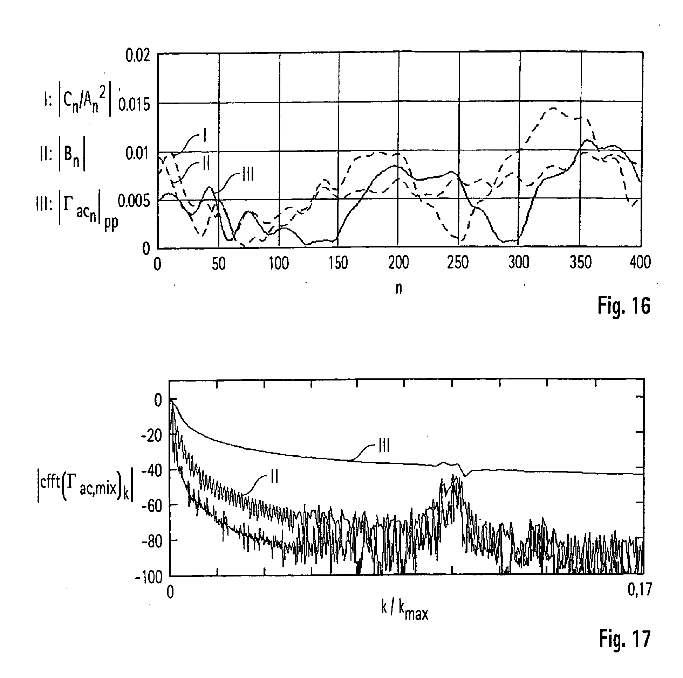

Fig. 16 zeigt das Ergebnis der so aus den gemessenen Reflexionskoeffizienten berechneten Werte für den Betrag der effektiven Direktivität und den Betrag der effektiven Quelltor-Anpassung und zwar im Vergleich zum Betrag der Ripple-Amplitude der Oszillation, die dem Betrag des Reflexionskoeffizienten überlagert ist. Fig. 16 zeigt, daß zwischen dieser bisher ausschließlich ausgewerteten Ripple-Amplitude und den erfindungsgemäß gemessenen Werten erhebliche Abweichungen bestehen, wobei die erfindungsgemäß gemessenen und getrennt ausgewerteten Werte wesentlich genauer sind.

Für die Anwendbarkeit des erfindungsgemäßen Verfahrens ist es ganz wesentlich, daß sich die "Spektren" der Komponenten $B$ und $C$ nicht mit denen des Trägers $A$ überlappen, d.h. daß die Entfernungen der in $B$ und $C$ enthaltenen Reflexionen von der Referenzebene geringer sind als die Länge der Luftleitung. Das wiederum bedeutet, daß 'residual system directivity' und 'residual system port impedance match' keine Anteile des physischen Netzwerkanalysators mehr enthalten sollten, sondern nur noch Anteile, die von der Unzulänglichkeit der verwendeten Kalibrierstandards herrühren. Daher kann das erfindungsgemäße Verfahren immer erst nach einer Systemkalibrierung des VNA durchgeführt werden.

Eine ganz wesentliche Schwierigkeit bei der Gewinnung spektraler Anteile aus einem endlichen Zeitabschnitt ergibt sich dadurch, daß die Fourier-Transformation das Spektrum des periodisch wiederholten Signalausschnitts bildet. Abgesehen von der frequenzmäßigen Diskretisierung entstehen dadurch spektrale Komponenten, die im Signal eigentlich nicht vorhanden sind. Wenn nun aus diesem verfälschten Spektrum die gesuchten Anteile ausgeschnitten werden, entfallen zwangsweise auch einige der durch die periodische Wiederholung hinzugekommenen Linien, so daß der zeitliche Verlauf nach der Rücktransformation zusätzlich verfälscht wird.

Es sind zwei Methoden bekannt, um diesen Effekt zu verringern. Zum einen kann man den Signalabschnitt vor der Fourier-Transformation einer Fensterung unterwerfen, so daß das Signal nahe Null beginnt und endet und damit nur geringe spektrale Verfälschungen entstehen. Allerdings kann man dann auch nicht damit rechnen, daß Anfang und Ende nach der Rücktransformation stimmen, d.h. das Verfahren funktioniert nicht über den ganzen Signalabschnitt, z.B. nur über den Bereich 8 GHz bis 32 GHz bei einem sich über 100 MHz bis 40 GHz erstreckenden Satz von Meßwerten.

Bei der zweiten bekannten Methode wird an den vorhandenen Signalabschnitt noch einmal der gespiegelte Verlauf angehängt, was zumindest einen stetigen Verlauf und damit geringere spektrale Verfälschungen des periodisch wiederholten Signals erzwingt. Trotzdem sind auch hier nach der Rücktransformation Anfang und Ende des Signalabschnitts nur unter Einschränkungen verwendbar.

Das erfindungsgemäße Verfahren nutzt ebenfalls die Möglichkeit der Spiegelung, führt jedoch vorher eine Extrapolation des Signalabschnitts über das Ende und den Anfang (in Richtung 'negativer Frequenzwerte') durch. Zur Extrapolation wird ein linearer Prädiktor verwendet, welcher zu einem stetigen und - in frequenzkontinuierlicher Betrachtungsweise - differenzierbaren Verhalten an den Endpunkten führt. Nach Verdoppelung des Signalabschnitts durch Spiegelung erfolgt die diskrete (komplexe) Fouriertransformation (DFT), Gewinnung des gewünschten Spektralanteils und Rücktransformation. Anschließend werden die ohnehin nur gering verfälschten Randabschnitte, d.h. die extrapolierten Anteile, abgeschnitten und das verbleibende Signal weiterverarbeitet.

Lineare Prädiktion gestattet es, die extrapolierten Werte als Linearkombination vorangegangener Werte zu berechnen:

$$\Gamma_{ac_n} = \sum_{e=1}^{E} a_e \, \mathrm{Re}\!\left(\Gamma_{ac_{n-e}}\right) + j \sum_{e=1}^{E} b_e \, \mathrm{Im}\!\left(\Gamma_{ac_{n-e}}\right) \qquad (33)$$

Die Gewichte $a_e$ und $b_e$ werden dabei so bestimmt, dass die Anwendung von Gleichung (33) innerhalb des gemessenen Signalabschnitts zu möglichst kleinen Fehlern führt. Die mathematischen Verfahren zu ihrer Bestimmung sind in der einschlägigen Literatur beschrieben. Es hat sich gezeigt, daß eine Verlängerung des gemessenen Signalabschnitts auf den doppelten Wert für die Zwecke der Erfindung normalerweise ausreicht. Durch das Hinzufügen von noch mehr Punkten, und zwar möglichst bis zu einem lokalen Extremum des Betrags (Fig. 18), wird einerseits die Frequenzauflösung weiter erhöht und andererseits die Möglichkeit für eine erhöhte Selektivität des Verfahrens geschaffen (Fig. 17). Letzteres ist dann wichtig, wenn das Basisband und das Frequenzband bei der doppelten Trägerfrequenz relativ breit sind und nahe an den Träger heranreichen (von Reflexionen hervorgerufen, die relativ weit von der Referenzebene entfernt sind).

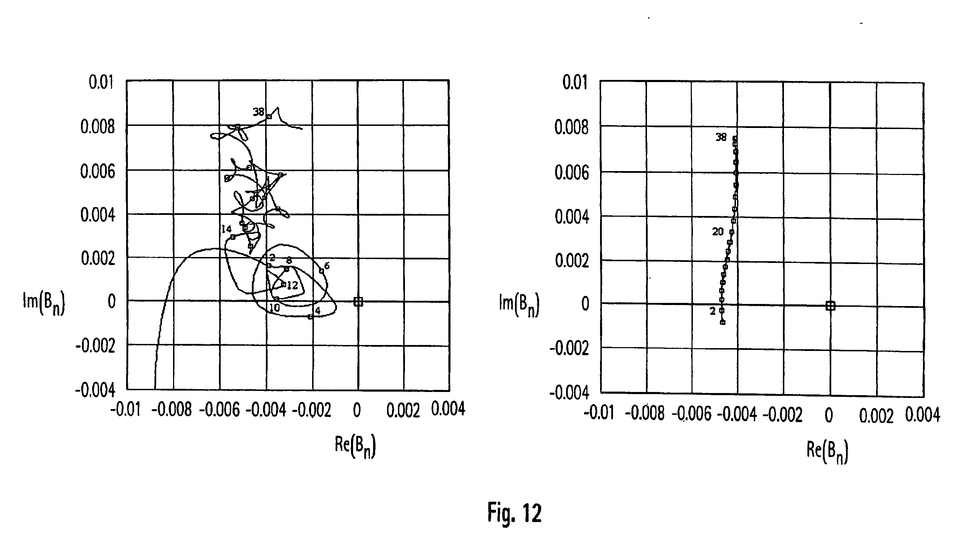

Die gesuchten spektralen Komponenten werden durch Tiefpaßfilterung und abschließende Rücktransformation gewonnen. Es genügt vollkommen, 'ideale' Tiefpässe mit rechteckförmiger Übertragungsfunktion (1 im Durchlass-, 0 im Sperrbereich) zu verwenden, deren Bandbreite so gewählt ist, daß der Übergang vom Durchlaß- in den Sperrbereich in der Mitte zwischen den zu trennenden spektralen Komponenten liegt. Eine Einschränkung der Bandbreite unter diesen Wert führt einerseits zu einer (erwünschten) Verringerung des dem Meßergebnis überlagerten Rauschens, andererseits kann sie Verfälschungen des Meßergebnisses zur Folge haben, wenn dadurch relevante spektrale Anteile eliminiert werden. In der Praxis wird man einen Kompromiss finden müssen, wobei die Wahl der Bandbreite für die dargestellte Meßaufgabe als unkritisch eingestuft werden konnte (Fig. 14 und 15). Selbst bei extremer Reduzierung (Fig. 12 rechts) konnten noch vernünftige Meßergebnisse erzielt werden. Wenn man sich vor Augen hält, daß die vorangegangene Systemkalibrierung mit der OSM-Methode (Kalibrierstandards Open, Short und Match) durchgeführt und als 'Match' eine ab 4GHz Gleitlast (sliding load) verwendet wurde, ist das Ergebnis auch leicht erklärbar: Da sich die Luftleitungsabschnitte von Gleitlast und Referenz-Luftleitung im wesentlichen durch ihre charakteristische (frequenzunabhängige und reelle) Impedanz sowie die proportional zur Frequenz ansteigenden Reaktanzen der Steckverbindungen an der Referenzebene unterscheiden, ist auch rein theoretisch ein Verlauf wie in Fig. 12 (rechts) zu erwarten.

2. Fall: $|\Gamma_1| < 0{,}1$ (Verifikation mit kleinem ausgangsseitigen Fehlabschluß)

Die Auswertung kann genau nach dem gleichen Schema wie für die Verifikation mit Kurzschluß vorgenommen werden (Punkt 11 entfällt). Das Ergebnis für die effektive Direktivität ('residual system directivity') sollte identisch mit jenem sein, das bei der Verifikation mit Kurzschluß gewonnen wurde. An die Größe des Fehlabschlusses im Verhältnis zur effektiven Direktivität werden keine Anforderungen gestellt (im Gegensatz zur Ripple-Auswertung nach dem Stand der Technik).

Durch diskrete Fourier-Transformation (DFT) der verlängerten und gespiegelten Folge von Reflexionsmeßwerten entsteht eigentlich ein der Impulsantwort des Systems vergleichbares Zeitsignal. Wenn dafür vorstehend trotzdem der Begriff "Spektrum" verwendet wurde, dann nur deswegen, weil die damit zusammenhängenden Begriffe und Vorstellungen geläufiger sind. Im übrigen kann man sich die Reflexionskoeffizienten über G1. (19) als Zeitsignal vorstellen, so daß der Begriff des "Spektrums" für die DFT der Reflexionskoeffizienten seine Berechtigung hat. Die verwendeten mathematischen Algorithmen sind ohnehin unabhängig von der Begrifflichkeit zu gebrauchen.

**Patentansprüche**

1. Verfahren zum Messen der effektiven Direktivität eines Meßtores (M) eines systemkalibrierten vektoriellen Netzwerkanalysators (N) durch Anschalten einer am Ausgang kurzgeschlossenen Präzisions-Luftleitung (L) und Messung des komplexen Reflexionskoeffizienten am Eingang dieser Präzisions-Luftleitung (L) an einer Folge von Meßpunkten innerhalb eines vorgegebenen Frequenzbereiches,
**dadurch gekennzeichnet,**
**daß** die Folge der gemessenen komplexen Reflexionskoeffizienten einer diskreten Fourier-Transformation unterworfen wird,
**daß** aus dem **dadurch** gebildeten Spektrum das Basisband ausgefiltert wird und aus den spektralen Anteilen dieses Basisbandes durch anschließende inverse Fourier-Rücktransformation die effektiven Direktivitäts-Werte berechnet werden.

2. Verfahren zum Messen der effektiven Quelltor-Anpassung eines Meßtores (M) eines systemkalibrierten vektoriellen Netzwerkanalysators (N) durch Anschalten einer am Ausgang kurzgeschlossenen Präzisions-Luftleitung (L) und Messung des komplexen Reflexionskoeffizienten am Eingang der Luftleitung (L) an einer Folge von Messpunkten innerhalb eines vorgegebenen Frequenzbereiches,
**dadurch gekennzeichnet,**
**daß** die Folge der gemessenen komplexen Reflexionskoeffizienten einer komplexen Fourier-Transformation unterworfen wird,
**daß** aus dem **dadurch** gebildeten Spektrum die Komponente maximaler Amplitude ausgefiltert und durch inverse Fourier-Rücktransformation die Größe (A) dieser Komponente bestimmt wird,
**daß** dann das obere Seitenband bei der doppelten Frequenz dieser Komponente maximaler Amplitude ausgefiltert und wiederum durch inverse Fourier-Rücktransformation die Größe (C) dieses ausgefilterten oberen Seitenbandes bestimmt wird und
**daß** schließlich durch Division der Größe (A) der Komponente maximaler Amplitude durch das Quadrat der Größe (C) des oberen ausgefilterten Seitenbandes die effektiven Quelltor-Anpassungs-Werte berechnet werden.

3. Verfahren zum Messen der effektiven Direktivität und der effektiven Quelltor-Anpassung eines Meßtores (M) eines systemkalibrierten vektoriellen Netzwerkanalysators (N) durch Anschalten einer am Ausgang kurzgeschlossenen Präzisions-Luftleitung (L) und Messung des komplexen Reflexionskoeffizienten am Eingang der Luftleitung (L) an einer Folge von Meßpunkten innerhalb eines vorgegebenen Frequenzbereiches,
**dadurch gekennzeichnet,**
**daß** die Verfahrensschritte nach Anspruch 1 und 2 kombiniert und gleichzeitig parallel ausgeführt werden.

4. Verfahren nach einem der vorhergehenden Ansprüche,
**gekennzeichnet durch**
die Verwendung einer Präzisions-Luftleitung (L), deren Impedanz von der Systemimpedanz des Netzwerkanalysators (N) um einen bekannten Wert abweicht, wobei diese bekannte Impedanzabweichung bei der Berechnung der Werte der effektiven Direktivität bzw. effektiven Quelltor-Anpassung als entsprechende Korrekturwerte berücksichtigt wird.

5. Verfahren nach einem der vorhergehenden Ansprüche,
**dadurch gekennzeichnet,**
**daß** vor der komplexen Fourier-Transformation der Folge der gemessenen komplexen Reflexionskoeffizienten diese Folge von komplexen Reflexionskoeffizienten durch lineare Prädikation extrapoliert wird und durch Spiegelung dieser extra-polierten Folge von komplexen Reflexionskoeffizienten die ursprüngliche Folge verlängert wird.

6. Verfahren nach Anspruch 5,
**dadurch gekennzeichnet,**
**daß** vor der linearen Prädikation die Folge von komplexen Reflexionskoeffizienten mit einem solchen Faktor multipliziert wird, daß die Komponente maximaler Amplitude durch Abwärtsmischung im Spektrum bei der Frequenz Null liegt.

7. Verfahren nach Anspruch 1 oder 3 bis 6,
**dadurch gekennzeichnet,**
**daß** nach Ausführung des Meßverfahrens nach Anspruch 1 oder 3 bis 6 an dem Meßtor (M) des systemkalibrierten vektoriellen Netzwerkanalysators (N) eine am Ausgang fehlabgeschlossene Luftleitung (L) mit dem Reflexionsko-

effizient <1> |$\Gamma_e$|<0,1 angeschlossen wird und die damit gemessenen komplexen Reflexionskoeffizienten gemäß den Verfahrensschritten nach Anspruch 1 oder 3 bis 6 berechnet werden.

**8.** Verfahren nach einem der vorhergehenden Ansprüche,
**dadurch gekennzeichnet,**
**daß** mit den gewonnenen Werten der effektiven Direktivität und/oder der effektiven Quelltor-Anpassung die Systemfehler-Terme des Netzwerkanalysators (N) korrigiert werden.

**9.** Verfahren nach einem der vorhergehenden Ansprüche 1 bis 7,
**dadurch gekennzeichnet,**
**daß** vor der Messung der effektiven Direktivität und/oder der effektiven Quelltor-Anspassung eine Systemkalibrierung des vektoriellen Netwerkanalysators (N) mittels Kalibrierstandards vorgenommen wird, und
**daß** die gewonnene Folge von Werten der effektiven Direktivität und/oder der effektiven Quelltor-Anpassung auf einem Datenträger abgespeichert wird, der zusammen mit den zur Systemkalibrierung des Netzwerkanalysators (N) benutzten Kalibrierstandards vertreibbar ist.

**10.** Kalibrierstandard-Satz zur Systemkalibrierung von vektoriellen Netzwerkanalysatoren (N) mit verschiedenen vorzugsweise in Koaxialleitungstechnik ausgebildeten Kalibrierstandards für Leerlauf, Kurzschluß und Anpassung,
**dadurch gekennzeichnet,**
**daß** ihm ein Datenträger mit Werten der effektiven Direktivität und/oder effektiven Quelltor-Anpassung beigegeben ist, die gemäß dem Verfahren nach Anspruch 9 gewonnen sind.

**Claims**

**1.** Method for measuring the residual system directivity of a test port (M) of a system-calibrated vector network analyser (N) by connecting a precision air line (L) shortcircuited at the output and measuring the complex reflection coefficient at the input of this precision air line (L) at a sequence of measuring points within a prescribed frequency range,
**characterised in that**
the sequence of measured complex reflection coefficients is subjected to a discrete Fourier transform,
that the baseband is filtered out of the spectrum thereby formed, and the residual system directivity values are calculated from the spectral components of this baseband by subsequent inverse Fourier retransformation.

**2.** Method for measuring the residual system port impedance match of a test port (M) of a system-calibrated vector network analyser (N) by connecting a precision air line (L) shortcircuited at the output and measuring the complex reflection coefficient at the input of the air line (L) at a sequence of measuring points within a prescribed frequency range,
**characterised in that**
the sequence of measured complex reflection coefficients is subjected to a complex Fourier transform,
that the component of maximum amplitude is filtered out from the spectrum thereby formed, and the value (A) of this component is determined by inverse Fourier retransformation,
that the upper sideband is then filtered out at double the frequency of the component of maximum amplitude and the value (C) of this filtered-out upper sideband is again determined by inverse Fourier retransformation, and
that the sequence of residual system port impedance match values is finally calculated by respective division of the value (A) of the component of maximum amplitude by the square of the value (C) of the upper filtered-out sideband.

**3.** Method of measuring the residual system directivity and the residual system port impedance match of a test port (M) of a system-calibrated vector network analyser (N) by connecting a precision air line (L) shortcircuited at the output and measuring the complex reflection coefficient at the input of the air line (L) at a sequence of measuring points within a prescribed frequency range,
**characterised in that**
the process steps of claims 1 and 2 are combined and executed simultaneously in parallel.

**4.** Method according to any one of the preceding claims,
**characterised by**
the use of a precision air line (L) with an impedance deviating from the system impedance of the network analyser (N) by a known value, wherein this known impedance deviation is taken into account as appropriate correction values in calculating the values of the residual system directivity and/or residual system port impedance match.

**5.** Method according to any one of the preceding claims,
**characterised in that**,
before the complex Fourier transform of the sequence of measured complex reflection coefficients, this sequence of complex reflection coefficients is extrapolated by linear prediction, and the original sequence is extended by reflecting this extrapolated sequence of complex reflection coefficients.

**6.** Method according to claim 5,
**characterised in that**,
before the linear prediction, the sequence of complex reflection coefficients is multiplied by a factor such that the component of maximum amplitude is disposed at the frequency zero in the spectrum as a result of down-mixing.

**7.** Method according to claim 1 or claims 3 to 6,
**characterised in that**,
after the implementation of the measuring method according to claim 1 or claims 3 to 6, an air line (L) incorrectly terminated at the output with the reflection coefficient $|\Gamma_e| < 0.1$ is connected to the test port (M) to be measured of the system-calibrated vector network analyser (N), and that the complex reflection coefficients measured as a result are then calculated in accordance with the process steps as set out in claim 1 or claims 3 to 6.

**8.** Method according to any one of the preceding claims,
**characterised in that**
the system error terms of the network analyser (N) are corrected by the values obtained for the residual system directivity and/or the residual system port impedance match.

**9.** Method according to any one of the preceding claims 1 to 7,
**characterised in that**,
before the measurement of the residual system directivity and/or the residual system port impedance match, a system calibration of the vector network analyzer (N) is implemented using calibration standards, and the sequence of values obtained for the residual system directivity and/or the residual system port impedance match is stored on a data medium, which may be operated together with the calibration standards used for system calibration of the network analyser (N).

**10.** Set of calibration standards for system calibration of vector network analysers (N) with various calibration standards for open-circuit, short-circuit and match, preferably using coaxial line technology,
**characterised in that**
it includes a data medium with values for the residual system directivity and/or the residual system port impedance match obtained according to the method set out in claim 9.

**Revendications**

**1.** Procédé de mesure de la directivité effective d'un port de mesure (M) d'un analyseur de réseau vectoriel à étalonnage systémique (N) au moyen du raccordement d'une conduite d'air de précision (L) court-circuitée à la sortie et au moyen de la mesure du coefficient de réflexion complexe à l'entrée de cette conduite d'air de précision (L) sur une succession de points de mesure à l'intérieur d'une zone de fréquences imposée,
**caractérisé en ce que**
la succession des coefficients de réflexion complexes mesurés est soumise à une transformation de Fourier discrète, **en ce que** la bande de base est sélectionnée par filtrage à partir du spectre formé de ce fait et **en ce que** les valeurs effectives de directivité sont calculées à partir des quote-parts spectrales de cette bande de base au moyen d'une retransformation de Fourier inverse réalisée à la suite.

**2.** Procédé de mesure de l'adaptation effective au port source d'un port de mesure (M) d'un analyseur de réseau vectoriel à étalonnage systémique (N) au moyen du raccordement d'une conduite d'air de précision (L) court-circuitée à la sortie et au moyen de la mesure du coefficient de réflexion complexe à l'entrée de la conduite d'air (L) sur une succession de points de mesure à l'intérieur d'une zone de fréquences imposée,
**caractérisé en ce que**
la succession des coefficients de réflexion complexes mesurés est soumise à une transformation de Fourier complexe, **en ce que** la composante d'amplitude maximale est sélectionnée par filtrage à partir du spectre formé de ce fait et la grandeur (A) de cette composante est déterminée au moyen d'une retransformation de Fourier inverse, **en**

**ce qu'**ensuite la bande latérale supérieure est sélectionnée par filtrage à la fréquence double de cette composante d'amplitude maximale et la grandeur (C) de cette bande latérale supérieure sélectionnée par filtrage est à nouveau déterminée au moyen d'une retransformation de Fourier inverse
et **en ce que** finalement les valeurs effectives de l'adaptation au port source sont calculées par une division de la grandeur (A) de la composante d'amplitude maximale par le carré de la grandeur (C) de la bande latérale supérieure sélectionnée par filtrage.

3. Procédé de mesure de la directivité effective et de l'adaptation effective au port source d'un port de mesure (M) d'un analyseur de réseau vectoriel à étalonnage systémique (N) au moyen du raccordement d'une conduite d'air de précision (L) court-circuitée à la sortie et au moyen de la mesure du coefficient de réflexion complexe à l'entrée de la conduite d'air (L) sur une succession de points de mesure à l'intérieur d'une zone de fréquences imposée, **caractérisé en ce que**
les étapes de procédé selon les revendications 1 et 2 sont réalisées de manière combinée et en même temps en parallèle.

4. Procédé selon l'une quelconque des revendications précédentes, **caractérisé par**
l'utilisation d'une conduite d'air de précision (L) dont l'impédance diverge d'une valeur connue par rapport à l'impédance systémique de l'analyseur de réseau (N), cette divergence connue de l'impédance étant prise en compte en tant que valeurs de correction correspondantes lors du calcul des valeurs de la directivité effective ou de l'adaptation effective au port source.

5. Procédé selon l'une quelconque des revendications précédentes, **caractérisé en ce que**
avant la transformation de Fourier complexe de la succession de coefficients de réflexion complexes mesurés, cette succession de coefficients de réflexion complexes est extrapolée par une prédication linéaire et que la succession initiale est rallongée par une réflexion spéculaire de cette succession extrapolée de coefficients de réflexion complexes.

6. Procédé selon la revendication 5, **caractérisé en ce que**
avant la prédication linéaire, la succession de coefficients de réflexion complexes est multipliée par un facteur tel que la composante d'amplitude maximale est, par un mélange descendant dans le spectre, située à la fréquence zéro.

7. Procédé selon les revendications 1 ou 3 à 6, **caractérisé en ce que**
après la réalisation du procédé de mesure selon les revendications 1 ou 3 à 6, une conduite d'air (L) qui est fermée de manière erronée à la sortie et qui dispose du coefficient de réflexion $|\Gamma_e| < 0{,}1$ est raccordée sur le port de mesure (M) de l'analyseur de réseau vectoriel à étalonnage systémique (N) et que les coefficients de réflexion complexes ainsi mesurés sont calculés selon les étapes de procédé des revendications 1 ou 3 à 6.

8. Procédé selon l'une quelconque des revendications précédentes, **caractérisé en ce que**
les termes des défauts systémiques de l'analyseur de réseau (N) sont corrigés au moyen des valeurs obtenues pour la directivité effective et/ou pour l'adaptation effective au port source.

9. Procédé selon l'une quelconque des revendications précédentes 1 à 7, **caractérisé en ce que**
un étalonnage systémique de l'analyseur de réseau vectoriel (N) est réalisé au moyen de standards d'étalonnage avant la mesure de la directivité effective et/ou de l'adaptation effective au port source et **en ce que** la succession de valeurs de la directivité effective et/ou de l'adaptation effective au port source qui est obtenue est mémorisée sur un support de données qui peut être commercialisé en même temps que les standards d'étalonnage utilisés pour l'étalonnage systémique de l'analyseur de réseau (N).

10. Jeu de standards d'étalonnage pour l'étalonnage systémique d'analyseurs de réseau vectoriels (N) avec différents standards d'étalonnage configurés de préférence en technologie à conduites coaxiales pour la marche à vide, pour le court-circuit et pour l'adaptation, **caractérisé en ce qu'**il lui est adjoint un support de données avec. des valeurs de la directivité effective et/ou de l'adaptation effective au port source qui sont obtenues conformément au procédé selon la revendication 9.

**Fig. 1**

**Fig. 2**

**Fig. 3**

**Fig. 4**

**Fig. 5**

$$\left|\underline{\mathrm{cfft}}\left(\Gamma_{ac}\right)_n\right|$$

n

Fig. 6

$$\left|\Gamma_{ac,mix_k}\right|$$

k

Fig. 7

Fig. 8

Fig. 9

Fig. 10

$$\underline{\left| \mathrm{cfft} \left( S_{ac} \right)_k \right|}$$

Fig. 11

$$\left| \mathrm{cfft} \left( S_{ac} / A^2 \right)_k \right|$$

Fig. 13

Fig. 12

Fig. 14

Fig. 15

I: $\left| C_n / A_n^2 \right|$

II: $\left| B_n \right|$

III: $\left| \Gamma_{ac_n} \right|_{pp}$

Fig. 16

$\left| cfft \left( \Gamma_{ac,mix} \right)_k \right|$

$k / k_{max}$

Fig. 17

Fig. 18

Fig. 19